# EUROPÄISCHE PATENTANMELDUNG

(11) **EP 4 600 529 A2**
(43) Veröffentlichungstag der Anmeldung: **13.08.2025**
(21) Anmeldenummer: 25185418.8
(22) Anmeldetag: 28.11.2018
(51) Int. Cl.: F16J 9/26

(54) **KOLBENRING**

(30) Priorität: 30.11.2017 DE 102017221606
(62) Teilanmeldung aus: 23192651.0
(71) Anmelder: Federal-Mogul Burscheid GmbH, 51399 Burscheid (DE)
(72) Erfinder: STUMPF, Walter, 45259 Essen (DE); HOPPE, Steffen, 51491 Overath (DE); LAMMERS, Ralf, 42929 Wermelskirchen (DE); LINDE, Rudolf, 42929 Wermelskirchen (DE)
(74) Vertreter: Hoffmann Eitle

(57) **Zusammenfassung**

Ein Kolbenring (10) weist eine Lauffläche (12) und Flankenflächen (14) auf, die beschichtet sind, wobei die oberste Schicht der Lauffläche (12) eine wasserstoffhaltige oder wasserstofffreie DLC-Schicht ist, und dadurch gekennzeichnet ist, dass die oberste Schicht zumindest einer Flankenfläche (14) eine Chromschicht ist.

Bei einem Verfahren zur Herstellung eines Kolbenrings (10) wird als oberste Schicht der Lauffläche (12) eine DLC-Schicht, und als oberste Schicht zumindest einer Flankenfläche (14) eine Chromschicht ausgebildet.

## Beschreibung

### Technisches Gebiet

Die Erfindung betrifft einen Kolbenring.

An Kolbenringe von Verbrennungsmotoren werden hohe Anforderungen im Hinblick auf einen möglichst geringen Verschleiß und eine möglichst geringe Reibung gestellt.

### Stand der Technik

Aus der DE 10 2014 213 822 ist diesbezüglich ein Kolbenring bekannt, der insbesondere im Hinblick auf ein gutes Verschleißverhalten auf der Lauf-, mit anderen Worten der Mantelfläche, eine DLC-Schicht aufweist. Die Flankenflächen sind nitriert, können jedoch eine Beschichtung aufweisen.

Die DE 10 2007 038 188 A1 betrifft einen Kolbenring mit einer galvanischen Chromschicht, auf der eine PVD-Schicht aufgebracht ist.

### Darstellung der Erfindung

Vor diesem Hintergrund liegt der Erfindung die Aufgabe zugrunde, einen im Hinblick auf das Verschleißverhalten und/oder die Reibung und/oder den Herstellungsaufwand verbesserten Kolbenring zu schaffen.

Die Lösung dieser Aufgabe erfolgt durch den in Anspruch 1 beschriebenen Kolbenring.

Demzufolge weist dieser beschichtete Lauf- und Flankenflächen auf, wobei die oberste Schicht der Lauffläche eine DLC-Schicht ist, und die oberste Schicht zumindest einer Flankenfläche eine Chromschicht ist. Bevorzugt ist zumindest die untere Flankenfläche, mit anderen Worten diejenige Flankenfläche eines Kolbenrings, die dafür vorgesehen ist, von dem Brennraum abgewandt zu sein, beschichtet. Die zweite Flankenfläche kann unbeschichtet oder beschichtet, insbesondere mit einer Chromschicht versehen sein. Die DLC-Schicht auf der Lauffläche sorgt für einen geringen Verschleiß und eine vergleichsweise geringe Reibung und ist darüber hinaus brandspurfest. Die Chromschicht auf zumindest einer Flankenfläche ist, beispielsweise verglichen mit einer DLC-Schicht, einfacher und kostengünstiger aufbringbar und sorgt darüber hinaus für einen geringen Verschleiß in diesem Bereich.

Darüber hinaus wird in Verbrennungsmotoren allgemein das Thema der Reibungsverminderung immer wichtiger, wozu die Chromschicht auf zumindest einer Flankenfläche einen vorteilhaften Beitrag leistet. Infolge der Bewegung des Kolbenrings im Betrieb ergibt sich nämlich auch hier Axial- und/oder Radialreibung, für die erwartet wird, dass sie mit der erfindungsgemäßen Chromschicht vergleichsweise gering ausfällt. Ferner ergibt sich verglichen mit nitrierten Flanken der Vorteil eines geringeren Verschleißes sowohl der Flankenflächen des Kolbenrings als auch der Kolbenringnut, insbesondere bei hoher Belastung und/oder ungünstigen Schmierbedingungen. Bei Versuchen konnte mit einem Stahlkolben für die erfindungsgemäße Chrombeschichtung verglichen mit nitriertem Chromstahl ein um mehr als 50% verringerter Verschleiß und eine deutlich verringerte Reibung festgestellt werden.

Der verringerte Verschleiß ist auch im Hinblick auf das sogenannte blow-by, mit anderen Worten einem ungewollten Ölstrom an dem Ölabstreifring vorbei, relevant. Ein hoher Verschleiß der Unterflanken von Kolbenringen in der ersten Nut verursacht nämlich ein erhöhtes blow-by. Wenn dieses die Ölabscheidewirkung der Motorentlüftung übersteigt, wird über den blow-by-Strom Öl aus dem Kurbelgehäuse transportiert, und der Ölverbrauch des Motors steigt in unzulässiger Weise an. Ferner kann sich der Kolbenring in der Nut bei zu hohem Verschleiß der Flankenflächen mit der Lauffläche nach unten bei Belastung verdrehen, so dass die untere Kante der Lauffläche Öl schlechter abstreift, und der Ölverbrauch ansteigt. Schließlich kann bei einem extremen Verschleiß der Flankenflächen, gegebenenfalls in Kombination mit einem Verschleiß der Kolbenringnut, der Kolbenring aufgrund eines zu hohen axialen Spiels in der Nut brechen.

Bevorzugte Weiterbildungen des erfindungsgemäßen Kolbenrings gehen aus den weiteren Ansprüchen hervor.

Für die DLC-Schicht werden besonders günstige Eigenschaften erwartet, wenn sie wasserstofffrei ist, in bestimmten Anwendungsfällen kann jedoch auch eine wasserstoffhaltige DLC-Schicht vorteilhaft sein.

Nachdem es prozesstechnisch Vorteile bietet, die Chromschicht zuerst auszubilden, kann die DLC-Schicht bereichsweise auf einer Chromschicht ausgebildet sein. Dies gilt sowohl für Lauf- als auch Flankenflächen.

Insbesondere kann es für die Herstellung Vorteile bieten, wenn die DLC-Schicht die Chromschicht im Bereich der Umfangskanten zumindest teilweise überlappt. Hierbei kann die Chromschicht zu der Umfangskante hin auslaufen, und/oder die Umfangskanten können unter einem definierten Winkel bearbeitet sein.

Im Hinblick auf die Ausbildung der DLC-Schicht wird ein PVD (Physical Vapour Deposition)-Verfahren bevorzugt.

Besondere Vorteile, insbesondere im Hinblick auf einen geringen Verschleiß werden erwartet, wenn die Chromschicht eine Härte von mindestens 800 HV 0,1 aufweist.

Für die Rissnetzdichte der Chromschicht wird insbesondere im Hinblick auf die möglichen Partikeleinlagerungen bevorzugt, dass diese eine Rissrate von 700 bis 1200 Risse/cm aufweist.

Im Hinblick auf eine konkrete Verringerung der Reibung im Bereich der Flankenflächen wird für die Chromschicht ein Reibkoeffizient im geschmierten Reibkontakt bevorzugt, der zumindest 20% geringer ist als der von nitriertem Chromstahl.

Aufgrund günstiger Erfahrungen wird für die Herstellung der Chromschicht eine galvanische Ausbildung bevorzugt.

Insbesondere kann hierbei eine Bearbeitung der Chromschicht, bevorzugt kombiniert mit einer galvanischen Aufbringung, derart erfolgen, dass die Rauheit der Flankenflächen nachfolgend geringer als Rz 4 ist.

Zur weiteren Verbesserung ihrer Eigenschaften, kann die Chromschicht Partikeleinlagerungen aufweisen, die insbesondere in das Rissnetzwerk der Chromschicht eingelagert sein können.

Die Lösung der oben genannten Aufgabe erfolgt ferner durch das im Anspruch 7 beschriebene Verfahren, das im Hinblick auf seine Verfahrensschritte dem erfindungsgemäß gestalteten Kolben entspricht. Es sei an dieser Stelle erwähnt, dass sämtliche vorangehend und nachfolgend angegebene Verfahrensschritte für den erfindungsgemäßen Kolbenring ebenfalls bevorzugt werden, und umgekehrt.

Insbesondere bietet es für den Prozessablauf Vorteile, wenn die Chromschicht, insbesondere galvanisch, vor der DLC-Schicht ausgebildet wird. Hierdurch können Probleme im Hinblick auf die schlechte Leitfähigkeit von DLC, die das galvanische Verfahren behindern würde, im Hinblick auf eine unerwünschte Wasserstoffgasbildung beim Verchromen und die chemische Aggressivität des Chrom-Elektrolyten gegenüber DLC vermieden werden.

### Kurze Beschreibung der Zeichnungen

Nachfolgend wird ein in den Zeichnungen dargestelltes Ausführungsbeispiel der Erfindung näher erläutert.
Fig. 1 zeigt einen Querschnitt durch einen erfindungsgemäßen Kolbenring.
Fig. 2 zeigt den in Fig. 1 gekennzeichneten Bereich in vergrößertem Maßstab.

### Ausführliche Beschreibung einer bevorzugten Ausführungsform der Erfindung

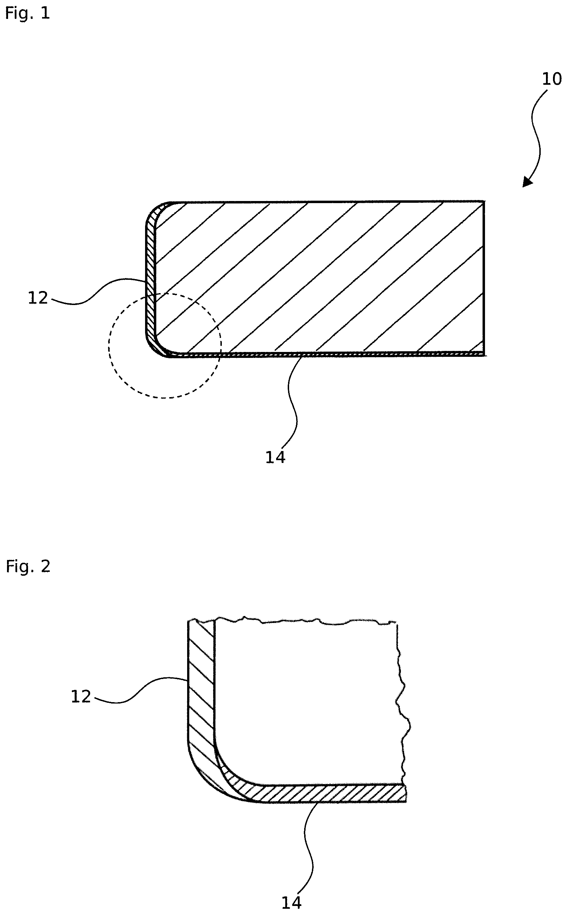

Wie in der Fig. 1 zu erkennen ist, weist ein Kolbenring 10 typischerweise einen rechteckigen Querschnitt mit einer Lauffläche 12 und hierzu im Wesentlichen senkrecht verlaufenden Flankenflächen auf, von denen die untere Flankenfläche mit 14 bezeichnet ist. Bei dem gezeigten bevorzugten Ausführungsbeispiel ist die untere Flankenfläche 14 mit einer Chromschicht, und die Lauffläche mit einer DLC-Schicht versehen. Hierbei ist die bevorzugte Maßnahme gezeigt, wonach die DLC-Schicht die Chromschicht insbesondere in dem Übergangsbereich zwischen Lauf- 12 und Flankenfläche 14 überlappt. Bei dem gezeigten Beispiel ist der Übergang gerundet ausgeführt, er kann jedoch ebenso schräg sein.

Wie insbesondere in Fig. 2 zu erkennen ist, erstreckt sich die Chromschicht mit abnehmender Dicke bis zu der (in den Figuren vertikalen) Lauffläche 12, und die DLC-Schicht ebenfalls mit abnehmender Dicke in etwa bis zu dem Beginn der (in den Figur horizontalen) Flankenfläche 14.

### Ausführungsformen

1. Kolbenring (10) mit zumindest einer Lauffläche (12) und Flankenflächen (14), die beschichtet sind, wobei die oberste Schicht der Lauffläche (12) eine wasserstoffhaltige oder wasserstofffreie DLC-Schicht ist, dadurch gekennzeichnet, dass die oberste Schicht zumindest einer, bevorzugt der unteren, Flankenfläche (14) eine Chromschicht ist.
**2.** Kolbenring (10) nach 1, dadurch gekennzeichnet, dass die DLC-Schicht wasserstofffrei ist.
**3.** Kolbenring (10) nach 1 oder 2, dadurch gekennzeichnet, dass sich zumindest bereichsweise unterhalb der DLC-Schicht eine Chromschicht befindet.
**4.** Kolbenring (10) nach 3, dadurch gekennzeichnet, dass die DLC-Schicht die Chromschicht im Bereich der Umfangskanten zumindest teilweise überlappt.
5. Kolbenring (10) nach einer der vorangehenden Ausführungsformen, dadurch gekennzeichnet, dass die DLC-Schicht durch ein PVD-Verfahren ausgebildet ist.
6. Kolbenring (10) nach einer der vorangehenden Ausführungsformen, dadurch gekennzeichnet, dass die Chromschicht eine Härte von mindestens 800 HV 0,1, aufweist.
7. Kolbenring (10) nach einer der vorangehenden Ausführungsformen, dadurch gekennzeichnet, dass die Chromschicht eine Rissnetzdichte mit einer Rissrate von 700 bis 1200 Risse/cm aufweist.
8. Kolbenring (10) nach einer der vorangehenden Ausführungsformen, dadurch gekennzeichnet, dass ein Reibkoeffizient der Chromschicht im geschmierten Reibkontakt um mindestens 20% geringer ist als der von nitriertem Chromstahl.
9. Kolbenring (10) nach einer der vorangehenden Ausführungsformen, dadurch gekennzeichnet, dass die Chromschicht galvanisch ausgebildet ist.
10. Kolbenring (10) nach einer der vorangehenden Ausführungsformen, dadurch gekennzeichnet, dass die Flankenfläche (14) eine Rauheit von kleiner als Rz 4 aufweist.
11. Kolbenring (10) nach einer der vorangehenden Ausführungsformen, dadurch gekennzeichnet, dass die Chromschicht Partikeleinlagerungen aufweist.
12. Verfahren zur Herstellung eines Kolbenrings (10), bei dem als oberste Schicht der Lauffläche (12) eine DLC-Schicht, und als oberste Schicht zumindest einer Flankenfläche (14) eine Chromschicht ausgebildet wird.
13. Verfahren nach 12, dadurch gekennzeichnet, dass die DLC-Schicht durch ein PVD-Verfahren ausgebildet wird.
14. Verfahren nach 12 oder 13, dadurch gekennzeichnet, dass die Chromschicht galvanisch ausgebildet wird.
15. Verfahren nach einer der Ausführungsformen 12 bis 14, dadurch gekennzeichnet, dass die Chromschicht vor der DLC-Schicht ausgebildet wird.
16. Verfahren nach einer der Ausführungsformen 12 bis 15, dadurch gekennzeichnet, dass die Chromschicht derart bearbeitet wird, dass sie eine Rauheit von kleiner Rz 4 aufweist.

## Patentansprüche

1. Kolbenring (10) mit einer Lauffläche (12), Flankenflächen (14), und einer Übergangsfläche zwischen der Lauffläche (12) und einer Flankenfläche (14), wobei die Lauffläche (12), die Flankenflächen (14), und die Übergangsfläche beschichtet sind, wobei die oberste Schicht der Lauffläche (12) eine wasserstoffhaltige oder wasserstofffreie DLC-Schicht ist, die oberste Schicht zumindest einer Flankenfläche (14) eine Chromschicht ist, und die Übergangsfläche gerundet ausgeführt ist.

2. Kolbenring (10) nach Anspruch 1, **dadurch gekennzeichnet, dass** die DLC-Schicht wasserstofffrei ist.

3. Kolbenring (10) nach Anspruch 1 oder 2, **dadurch gekennzeichnet, dass** sich zumindest bereichsweise unterhalb der DLC-Schicht eine Chromschicht befindet.

4. Kolbenring (10) nach Anspruch 3, **dadurch gekennzeichnet, dass** die DLC-Schicht die Chromschicht im Bereich der Umfangskanten zumindest teilweise überlappt.

5. Kolbenring (10) nach einem der vorangehenden Ansprüche, **dadurch gekennzeichnet, dass** die DLC-Schicht durch ein PVD-Verfahren ausgebildet ist.

6. Kolbenring (10) nach einem der vorangehenden Ansprüche, **dadurch gekennzeichnet, dass** die Chromschicht eine Härte von mindestens 800 HV 0,1, aufweist.

7. Kolbenring (10) nach einem der vorangehenden Ansprüche, **dadurch gekennzeichnet, dass** die Chromschicht eine Rissnetzdichte mit einer Rissrate von 700 bis 1200 Risse/cm aufweist.

8. Kolbenring (10) nach einem der vorangehenden Ansprüche, **dadurch gekennzeichnet, dass** ein Reibkoeffizient der Chromschicht im geschmierten Reibkontakt um mindestens 20% geringer ist als der von nitriertem Chromstahl.

9. Kolbenring (10) nach einem der vorangehenden Ansprüche, **dadurch gekennzeichnet, dass** die Chromschicht galvanisch ausgebildet ist.

10. Kolbenring (10) nach einem der vorangehenden Ansprüche, **dadurch gekennzeichnet, dass** die Flankenfläche (14) eine Rauheit von kleiner als Rz 4 aufweist.

11. Kolbenring (10) nach einem der vorangehenden Ansprüche, **dadurch gekennzeichnet, dass** die Chromschicht Partikeleinlagerungen aufweist.

12. Verfahren zur Herstellung eines Kolbenrings (10), bei dem als oberste Schicht der Lauffläche (12) eine DLC-Schicht, als oberste Schicht zumindest einer Flankenfläche (14) eine Chromschicht ausgebildet wird, und eine Übergangsfläche zwischen der Lauffläche (12) und einer Flankenfläche (14) gerundet ausgeführt wird.

13. Verfahren nach Anspruch 12, **dadurch gekennzeichnet, dass** die DLC-Schicht durch ein PVD-Verfahren ausgebildet wird.

14. Verfahren nach Anspruch 12 oder 13, **dadurch gekennzeichnet, dass** die Chromschicht galvanisch ausgebildet wird.

15. Verfahren nach einem der Ansprüche 12 bis 14, **dadurch gekennzeichnet, dass** die Chromschicht vor der DLC-Schicht ausgebildet wird.

16. Verfahren nach einem der Ansprüche 12 bis 15, **dadurch gekennzeichnet, dass** die Chromschicht derart bearbeitet wird, dass sie eine Rauheit von kleiner Rz 4 aufweist.
